Europäisches Patentamt

**European Patent Office**

**Office européen des brevets**

(11) Numéro de publication: **0 138 645**
**A1**

## (12) DEMANDE DE BREVET EUROPEEN

(21) Numéro de dépôt: **84401722.8**

(22) Date de dépôt: **28.08.84**

(51) Int. Cl.⁴: **G 01 B 17/02, C 23 F 4/00**

(30) Priorité: **09.09.83 FR 8314398**

(43) Date de publication de la demande: **24.04.85**
**Bulletin 85/17**

(84) Etats contractants désignés: **DE GB**

(71) Demandeur: **THOMSON-CSF, 173, Boulevard Haussmann, F-75379 Paris Cedex 08 (FR)**

(72) Inventeur: **Defranould, Philippe, THOMSON-CSF SCPI 173, bld Haussmann, F-75379 Paris Cedex 08 (FR)**
Inventeur: **Penavaire, Louis, THOMSON-CSF SCPI 173, bld Haussmann, F-75379 Paris Cedex 08 (FR)**

(74) Mandataire: **Desperrier, Jean-Louis et al, THOMSON-CSF SCPI 173, Bld Haussmann, F-75379 Paris Cedex 08 (FR)**

(54) **Procédé de mesure de la profondeur d'une gravure ionique.**

(57) L'invention concerne les procédés de gravure ionique.

Elle consisite à mesurer en permanence la profondeur atteinte par une telle gravure en usinant simultanément les plaquettes à graver (14) et un dispositif à ondes acoustiques de surface (20) aménagé pour que la vitesse des ondes dépende de la profondeur de gravure. Cette vitesse est mesurée par une variation du retard des ondes et on en déduit la profondeur de gravure.

Elle permet d'arrêter les opérations de gravure lorsque la profondeur exacte est atteinte.

# PROCEDE DE MESURE DE LA PROFONDEUR D'UNE GRAVURE IONIQUE

La présente invention se rapporte aux procédés de mesure de la profondeur d'une gravure ionique qui permettent de mesurer en permanence la profondeur atteinte par une telle gravure pendant le fonctionnement même de l'appareil de gravure ionique. Ceci permet d'arrêter le fonctionnement de cet appareil lorsque la profondeur désirée est atteinte et d'obtenir ainsi un maximum de précision sur celle-ci.

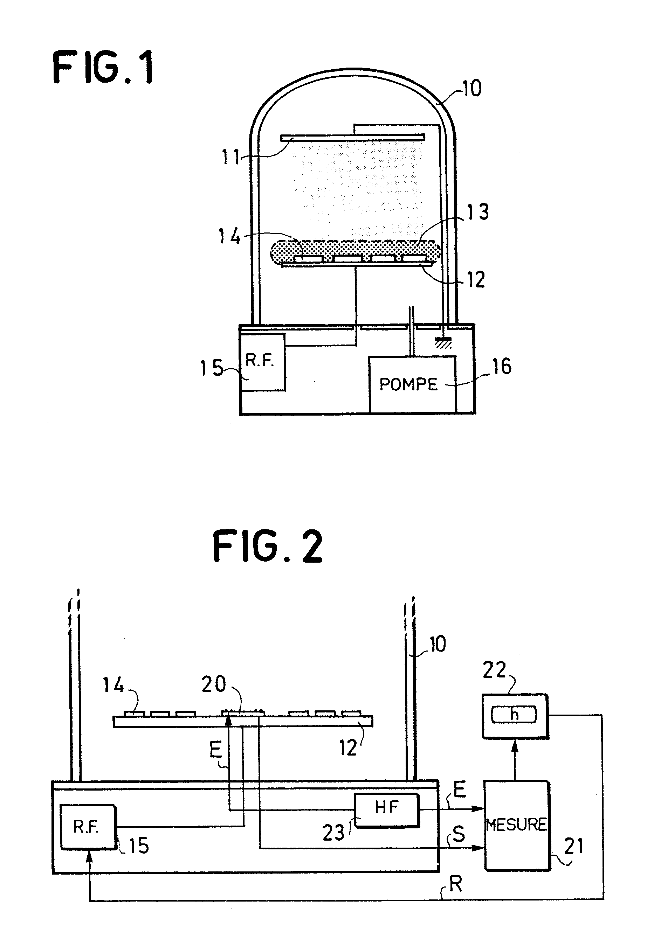

Le schéma d'un appareil à gravure sèche par bombardement ionique est représenté sur la figure 1. Dans une enceinte 10, dans laquelle on a fait le vide au préalable à l'aide d'une pompe 16, on introduit un gaz qui est ionisé au moyen d'un fort champ électrique créé entre deux plateaux 11 et 12.

Ce champ électrique est obtenu par une tension continue ou haute fréquence RF appliquée entre les deux plateaux par un générateur 15.

Au voisinage de l'électrode positive se forme une "gaine d'ions" 13 dans laquelle on obtient des vitesses d'ions élevées et relativement stables permettant un usinage mécanique de métaux tels que l'or ou l'aluminium, ou de diélectrique tels que le quartz ou le niobate de lithium.

Les plaquettes 14 de substrats à graver sont placées sur le plateau 12 qui forme cette électrode positive.

Afin d'accélérer l'usinage on utilise généralement un gaz chimiquement actif qui agit sélectivement sur le matériau à usiner, d'où le nom de gravure ionique réactive.

On n'effectue pas de mesure de la profondeur de gravure pendant l'usinage, et pour obtenir une profondeur déterminée on arrête celui-ci à un instant connu a priori par des étalonnages préalables. Cette méthode présente l'inconvénient d'être imprécise car la reproductibilité de la vitesse de gravure n'est pas parfaite à cause des variations des paramètres, tels que la pression ou la température, au niveau de la "gaine d'ions" 13.

Afin de mesurer la profondeur de la gravure au fur et à mesure que se déroule l'usinage, l'invention propose d'usiner simultanément avec les plaquettes à graver un dispositif à ondes acoustiques de surface dont le signal de sortie permet d'obtenir la mesure désirée.

D'autres particularités et avantages de l'invention apparaîtront clairement dans la description suivante présentée à titre d'exemple non limitatif et faite en regard des figures annexées qui représentent :

- la figure 1, le schéma d'un appareil de gravure connu ;

- la figure 2, le schéma d'un appareil de gravure comportant des moyens de mesure de la profondeur de gravure ;

- la figure 3, le schéma d'un dispositif à ondes de surface utilisable dans l'appareil de la figure 2 ;

- la figure 4, une coupe du dispositif de la figure 3 ;

- la figure 5, une vue partielle de la figure 4 montrant l'action de la gravure ;

- la figure 6, le schéma d'un oscillateur utilisant un dispositif à ondes de surface utilisable dans l'appareil de la figure 2 ;

- la figure 7, le schéma d'un résonateur à ondes de surface utilisable dans le schéma de la figure 6.

Dans l'appareil de gravure représenté partiellement sur la figure 2, on a disposé sur le plateau 12 un ensemble de plaquettes à graver telles que 14 et un dispositif à ondes acoustiques de surface 20.

Un dispositif 23 tel que par exemple un oscillateur haute fréquence (HF) est relié au dispositif 20 pour lui appliquer un signal d'entrée E.

En réponse le dispositif envoie un signal de sortie S.

Ces deux signaux sont appliqués à un appareil de mesure 21 qui procède au traitement nécessaire pour obtenir la mesure sous une forme exploitable telle que par exemple un signal numérique donnant la valeur en microns de la profondeur de gravure obtenue à l'instant même.

Ce signal est alors appliqué à un appareil de visualisation 22, un afficheur numérique dans cet exemple, sur lequel on peut lire cette profondeur de gravure.

L'afficheur 22 peut être complété par un dispositif à seuil qui adresse un signal de coupure R au générateur 15 dès que la profondeur voulue, préalablement affichée, est atteinte.

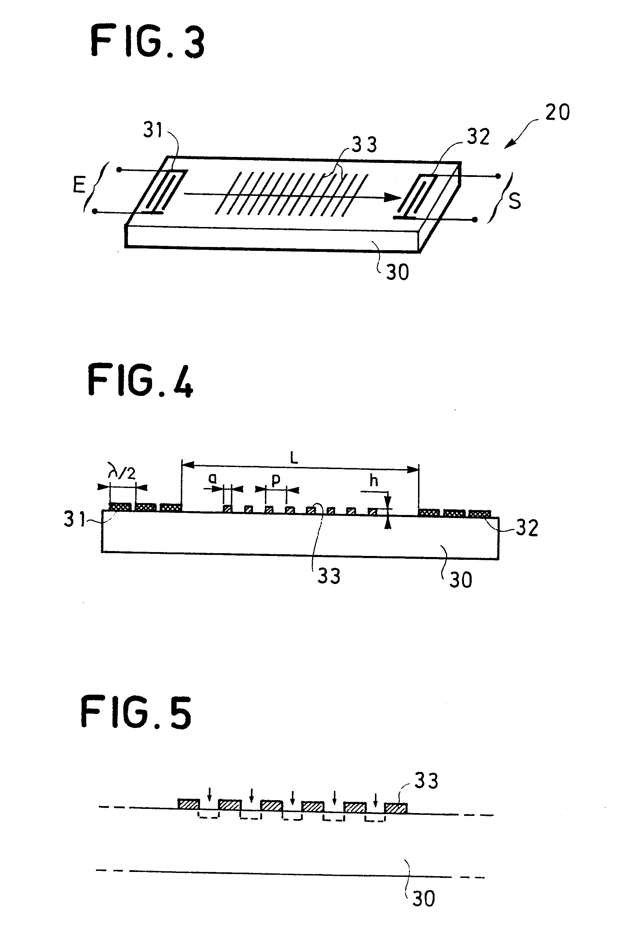

Le dispositif 20 utilisé est avantageusement une ligne à retard à ondes acoustiques de surface telle que représentée en perspective en figure 3 et en coupe en figure 4.

Il comporte sur un substrat piézoélectrique 30 en matériau adapté aux conditions de gravure, du quartz le plus souvent, un transducteur d'entrée 31 et un transducteur de sortie 32 en forme de peignes interdigités.

Les doigts des peignes de polarités opposées de ces transducteurs sont espacés de $\lambda/2$, $\lambda$ étant la longueur d'onde, à la fréquence f (plusieurs mégahertz) du signal d'excitation E, des ondes élastiques qui se développent à la surface du substrat sous l'action de ce signal lorsqu'il est appliqué au transducteur d'entrée.

Ces ondes se propagent à la vitesse v vers le transducteur de sortie, et l'on a donc :

$$\lambda = \frac{v}{f}$$

Si L est la distance entre les deux transducteurs, le retard entre le signal d'entrée E et le signal de sortie S est donné par :

$$T = \frac{L}{v}$$

Il est connu de modifier cette vitesse de propagation v en ajoutant sur la surface du substrat une couche continue ou discontinue d'un matériau différent de celui du substrat.

Dans cet exemple de réalisation on a déposé sur la surface du substrat 30 un réseau de discontinuités périodiques formé d'un ensemble de traits tel que 33 perpendiculaires à la direction de propagation des ondes entre les deux transducteurs. Ces traits ont une longueur sensiblement égale à celle des dents des peignes, une largeur a et une hauteur h. Ils sont équidistants entre eux d'un pas p. De manière courante le rapport a/p est égal à 0,5.

Dans le cas où les traits sont formés d'un matériau métallique, on observe un ralentissement $\Delta v$ de la vitesse de propagation des ondes donné par :

$$\frac{\Delta v}{v} = C + B\left(\frac{h}{\lambda}\right) + A.N\left(\frac{h}{\lambda}\right)^2 \qquad (1)$$

où A, B, C sont des constantes et N est le nombre de traits par longueur d'onde.

Ce ralentissement, et donc le retard T entre les signaux E et S, est ainsi fonction croissante de l'épaisseur h.

Cette épaisseur h varie pendant l'opération de gravure, soit en augmentant si le substrat est attaqué, soit en diminuant si ce sont les traits qui sont attaqués.

Pour mesurer les variations de h il suffit donc de mesurer les variations de T et de remonter à h soit par le calcul, soit par un étalonnage préalable.

Dans le cas d'une simple ligne à retard, on peut mesurer la variation $\Delta T$ de T en mesurant la variation de phase $\Delta \varphi$ entre le signal d'entrée et le signal de sortie S. On aura alors :

$$\Delta T = \frac{\Delta \varphi}{2\ f}$$

Pour accélérer la vitesse de gravure, et/ou pour attaquer sélectivement les zones à creuser, on utilise le plus souvent comme gaz de remplissage de l'enceinte 10 un gaz réactif qui attaque ces zones. Dans ce cas les matériaux constituant le dispositif à onde de surface sont choisis en conséquence pour obtenir la même vitesse d'attaque.

Si le matériau des plaquettes à graver est un métal, on utilise de préférence le même métal pour former les traits 33. Par contre, les transducteurs 31 et 32 sont alors constitués d'un métal différent qui ne réagit pas au gaz réactif, ou bien ils sont protégés.

Il est alors plus simple dans le cas d'une ligne à retard utilisée en tant que telle d'avoir une métallisation continue entre les deux transducteurs. En effet, dans ce cas, le nombre N de la formule (1) est égal à zéro, et $\frac{\Delta v}{v}$, et donc $\frac{\Delta T}{T}$, varient linéairement avec h, ce qui facilite les calculs.

Si le matériau des plaquettes à graver est un diélectrique, par exemple du quartz, il reste nécessaire de garder une structure comportant des traits métalliques. En effet ces traits forment des masques pour l'attaque par un gaz attaquant sélectivement le substrat ainsi que représenté en figure 5.

Dans ce cas, la hauteur h augmente au cours de l'usinage, entraînant une diminution de la vitesse v et donc une augmentation de T.

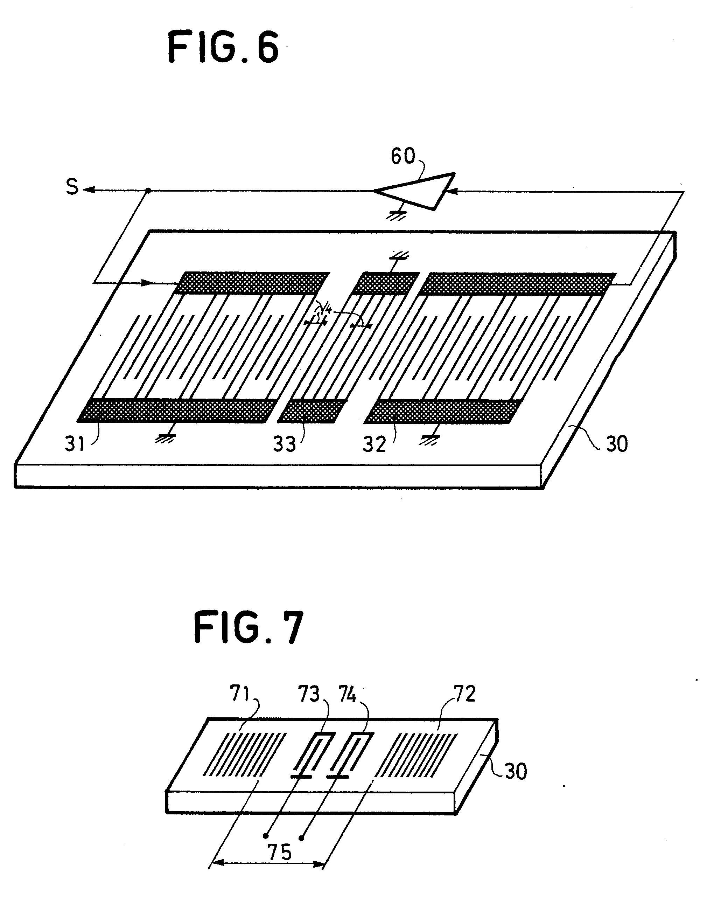

Une première variante de réalisation consiste à insérer la ligne à retard dans une boucle d'oscillation en reliant l'entrée et la sortie de cette ligne à retard par l'intermédiaire d'un amplificateur 60 comme représenté figure 6.

De manière connue ce montage oscille lorsque le gain de l'amplificateur compense la perte d'insertion de la ligne, selon au moins une fréquence déterminée par la relation $\phi_A + 2\pi fT = 2k\pi$ entre le déphasage de l'amplificateur entre son entrée et sortie, et le retard T de ligne.

Pour que la ligne à retard soit adaptée au mieux à ce montage, et qu'entre autres on ne sélectionne qu'une seule fréquence d'oscillation (oscillateur monomode avec k = 1), cette ligne est réalisée de la manière particulière représentée sur la figure. Notamment l'espace entre les transducteurs est faible vis-à-vis de la longueur de ceux-ci, qui présentent de plus la forme de peignes interdigités dont les doigts sont dédoublés avec un écartement de $\lambda/4$.

De plus le réseau de traits métalliques 33 situés entre les transducteurs, dont la présence modifie la vitesse des ondes acoustiques de surface à cet endroit, est relié à la masse métallique électrique de l'oscillateur et ces traits sont de préférence séparés d'une distance égale à $\lambda/4$.

Dans ces conditions, si le retard de la ligne varie de $\Delta T$ à cause d'une variation $\Delta h$ de l'épaisseur des traits 33, la fréquence d'oscillation varie d'une valeur $\Delta f$ telle que :

$$\frac{\Delta f}{f} = - \frac{\Delta T}{T} = \frac{\Delta v}{v}$$

Il n'est plus nécessaire alors d'avoir un oscillateur HF extérieur tel que 23. L'amplificateur 60 fait partie des moyens de mesure 21 et le signal S de mesure est avantageusement pris à l'entrée de la ligne à retard, où son niveau est le plus fort.

On peut mesurer la fréquence d'oscillation directement avec un fréquencemètre et en déduire la hauteur h, mais il est plus facile d'utiliser deux oscillateurs distincts calés sur deux fréquences distinctes f et f'. Dans ces conditions on obtient une relation linéaire entre la variation de profondeur $\Delta h$ et les variations relatives $\Delta f/f$ et $\Delta f'/f'$ de ces fréquences. Cette relation est donnée, avec $K = \frac{f'}{f}$ , par :

$$\frac{\Delta h}{\lambda} = \frac{K^2(\Delta f/f) - (\Delta f'/f')}{K(K-1)B}$$

Une deuxième variante de réalisation consiste à utiliser dans une boucle d'oscillation semblable à celle de la figure 6 un résonateur tel que représenté en figure 7, à la place de la ligne à retard.

6

Ce résonateur est lui aussi un dispositif à ondes acoustiques de surface qui comporte sur un substrat cristallin piézoélectrique 30 deux réseaux réfléchissants 71 et 72 séparés par un espace 75. Ces réseaux sont formés par exemple de traits métalliques parallèles espacés d'un pas p. Leur coefficient de réflexion est maximal pour une fréquence de résonance $f = v/2p$ où v est la vitesse de propagation des ondes sous les réseaux. Ces deux réseaux forment ainsi une cavité résonante accordée sur la fréquence f.

Pour coupler cette cavité à la boucle d'oscillation on utilise deux transducteurs interdigités 73 et 74.

Là aussi la vitesse de propagation des ondes acoustiques sous les réseaux est fonction de la profondeur h des traits formant ces réseaux. La fréquence de résonance varie donc en fonction de cette profondeur ce qui permet de mesurer les variations de la même manière que plus haut.

## REVENDICATIONS

1. Procédé de mesure de la profondeur d'une gravure ionique, caractérisé en ce que l'on grave simultanément au moins un dispositif à graver (14) et au moins un dispositif à ondes acoustiques de surface (20), et que l'on fait fonctionner ce dispositif à ondes de surface pendant l'opération de gravure pour déterminer la profondeur à mesurer à partir des variations du fonctionnement du dispositif.

2. Procédé selon la revendication 1, caractérisé en ce que le dispositif à ondes acoustiques de surface (20) comporte un substrat (30) sur la surface duquel se propagent les ondes, et une couche (33) déposée à la surface de ce substrat qui modifie la vitesse des ondes en fonction de son épaisseur.

3. Procédé selon la revendication 2, caractérisé en ce que la couche est gravée pour dégager la surface du substrat selon un ensemble de traits (33) sensiblement perpendiculaires à la direction de propagation des ondes et répartis avec un pas constant.

4. Procédé selon l'une quelconque des revendications 1 à 3, caractérisé en ce que le dispositif (20) est une ligne à retard dont le retard évolue en fonction de la profondeur de gravure.

5. Procédé selon la revendication 4, caractérisé en ce que l'on mesure le retard de la ligne en mesurant le déphasage d'un signal entre l'entrée (31) et la sortie (32) de celle-ci.

6. Procédé selon la revendication 5, caractérisé en ce que l'on insère la ligne à retard dans une boucle d'oscillation comportant au moins un amplificateur (60), et que l'on mesure le retard de la ligne en mesurant la fréquence d'oscillation de la boucle.

7. Procédé selon l'une quelconque des revendications 1 à 3, caractérisé en ce que le dispositif (20) est un résonateur dont la fréquence de résonance évolue en fonction de la profondeur de gravure, et que l'on mesure cette fréquence de résonance en insérant celui-ci dans une boucle d'oscillation comportant au moins un amplificateur (60).

8. Procédé selon l'une quelconque des revendications 6 et 7, caractérisé en ce que l'on utilise deux dispositifs (20) ayant des fréquences de résonance différentes et que l'on mesure la différence des fréquences d'oscillation.

0138645

1/3

FIG.1

FIG.2

# FIG.3

# FIG.4

# FIG.5

# FIG.6

# FIG.7

0138645

**Office européen des brevets**

## RAPPORT DE RECHERCHE EUROPEENNE

Numéro de la demande

EP 84 40 1722

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IEEE, PROCEEDINGS OF THE ULTRASONIC SYMPOSIUM, Monterey, 5-7 novembre 1973, (73 CHO 807-8SU), pages 525-529, IEEE, New York, USA; R.B. HEMPHILL: "A surface wave thickness monitor for thin evaporated films" * En entier * | 1-6 | G 01 B 17/02 C 23 F 4/00 |
| A | US-A-4 364 016 (SPERRY) * En entier * | 1-4,6-8 | |
| A | REVIEW OF SCIENCE INSTRUMENTS, vol. 48, no. 7, juillet 1977, pages 420-422, New York, USA; S. KOVNOVICH et al.: "Surface-acoustic-wave film thickness monitor" * En entier * | 1,2,4,6-8 | |
| A | US-A-4 278 492 (HEWLETT-PACKARD) * Figures; colonne 2, ligne 24 - colonne 4, ligne 16; revendications * | 1,2,4,6,7 | G 01 B 17/00 G 01 B 5/00 G 10 K 11/00 H 01 J 37/00 C 23 F 4/00 H 03 H 3/00 |
| A | GB-A-1 219 290 (SOUTH AFRICAN INVENTIONS DEVELOPMENT) * En entier * | 1,2,4,5 | |

DOMAINES TECHNIQUES RECHERCHES (Int. Cl.4)

---

-/-

Le présent rapport de recherche a été établi pour toutes les revendications

| Lieu de la recherche | Date d'achèvement de la recherche | Examinateur |
|---|---|---|
| LA HAYE | 26-11-1984 | BROCK T.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

Office européen
des brevets

**RAPPORT DE RECHERCHE EUROPEENNE**

EP 84 40 1722

| DOCUMENTS CONSIDERES COMME PERTINENTS | | | Page 2 |
|---|---|---|---|
| Catégorie | Citation du document avec indication, en cas de besoin, des parties pertinentes | Revendication concernée | CLASSEMENT DE LA DEMANDE (Int. Cl.4) |
| A | GB-A-2 052 339 (TEGAL)<br>* Figures 1-3,5; page 1, ligne 5 - page 2, ligne 128; page 2, ligne 15 - page 3, ligne 114; revendications 1,2 *<br><br>----- | 1 | |
| | | | **DOMAINES TECHNIQUES RECHERCHES (Int. Cl.4)** |
| Le présent rapport de recherche a été établi pour toutes les revendications | | | |

| Lieu de la recherche | Date d'achèvement de la recherche | Examinateur |
|---|---|---|
| LA HAYE | 26-11-1984 | BROCK T.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03 82